(19) Europäisches Patentamt

European Patent Office

Office européen des brevets

(11) EP 4 780 146 A1

(12) EUROPEAN PATENT APPLICATION

(43) Date of publication:
22.07.2026 Bulletin 2026/30

(51) International Patent Classification (IPC):
H05K 5/00 (2025.01)

(21) Application number: 25151937.7

(22) Date of filing: 15.01.2025

(52) Cooperative Patent Classification (CPC):
H05K 5/0056

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: ZF CV Systems Global GmbH
3006 Bern (CH)

(72) Inventors:
• GOLEMBIEWSKI, Adam
56-400 Olesnica (PL)
• PINDRAL, Piotr
98-200 Sieradz (PL)

(74) Representative: Copi, Joachim
ZF CV Systems Hannover GmbH
Am Lindener Hafen 21
30453 Hannover (DE)

(54) **HOUSING SECTION, HOUSING ASSEMBLY FOR HOUSING A PRINTED CIRCUIT BOARD, PRINTED CIRCUIT BOARD ASSEMBLY AND VEHICLE**

(57) The invention is directed to a housing section (100) of a housing assembly (200) for housing a printed circuit board based electrical circuit (202), which comprises a support structure (108) configured for receiving an elastic element (110) to be placed between the support structure (108) and the printed circuit board based electrical circuit (202). The support structure comprises, a distal end section (112) in a first direction (z), a plurality of protruding sections (114) that extend in a perpendicular second direction (x), wherein pairs of neighboring protruding sections (114) are linked in a perpendicular third direction (y) by a corresponding linking section (116) having a shorter extension in the third direction (x) than the protruding sections (114) and forming grooves (118) in the support structure (108) that extend in the first direction (z) from the distal end section (112).

**Fig. 3**

EP 4 780 146 A1

**Description**

The present invention relates to a housing section of a housing assembly for housing a printed circuit board (PCB) based electrical circuit to be arranged between said housing section and an additional cooperating second housing section. The present invention also related to a housing assembly for housing a printed circuit board based electrical circuit, to a printed circuit board assembly and to a vehicle.

Printed circuit boards are used in nearly all electronic products. A printed circuit board (PCB), also called printed wiring board (PWB), is a medium used to connect or "wire" components to one another in a circuit. It takes the form of a laminated sandwich structure of conductive and insulating layers: each of the conductive layers is designed with a pattern of traces, planes and other features (similar to wires on a flat surface) etched from one or more sheet layers of copper laminated onto or between sheet layers of a non-conductive substrate. Electrical components may be fixed to conductive pads on the outer layers, generally by means of soldering, which both electrically connects and mechanically fastens the components to the board. Another manufacturing process adds vias, drilled holes that allow electrical interconnections between conductive layers.

Printed circuit board based electrical circuits refer to electrical devices arranged on a printed circuit board and wherein electrical components are fixed to the PCB and electrically connected using the conductive layers of the PCB.

Housing assemblies for PCB based electrical circuit are known, for example from document EP 0 353 443 A2. They are also referred to as PCB mounting enclosures and are a piece of equipment that is used to store and protect a printed circuit board. They are typically configured to cover the PCB while still allowing an electrical interaction with the PCB based electrical circuit.

For applications where the PCB based electrical circuit is in motion, such as for automotive applications, the housing assemblies typically provide some vibration mitigation properties. Vibration mitigation refers to the reduction, or prevention in the case of vibration isolation, of the transmission of vibration from one component of a system to others parts of the same system. Vibration is undesirable in many domains, primarily engineered systems, and methods have been developed to prevent the transfer of vibration to such systems. Vibrations propagate via mechanical waves and certain mechanical linkages conduct vibrations more efficiently than others. Passive vibration isolation makes use of materials and mechanical linkages that absorb and damp these mechanical waves.

In some housing assemblies, an elastomeric strip is provided between the PCB-based electrical circuit and the housing assembly as a mechanical damper. The elastomeric strip is typically glued to the housing assembly, which requires additional steps in the production process for preparing the surface for the subsequent gluing strep.

It would be beneficial to enable a more cost-effective production process for housing assemblies, in particular for enabling cost-effective mechanical damping of PCB based electrical circuits.

This is where the invention comes in, wherein it is an objective of the present invention to provide a housing section for cost-effective mechanical damping in PCB.

A first aspect of the present invention is formed by a housing section of a housing assembly for housing a printed circuit board (PCB) based electrical circuit that is to be arranged between the housing section and a cooperating second housing section of the housing assembly. The housing section of the first aspect of the invention comprises a support structure that is arranged and configured for receiving an elastic element to be placed between the support structure and the printed circuit board. The support structure has a height extension in a first direction, a length extension in a second direction perpendicular to the first direction, and a width extension in a third direction perpendicular to the first direction and to the second direction.

According to the invention, the support structure comprises, at a distal end section thereof in the first direction, a plurality of protruding sections that extend in the third direction. Pairs of neighboring protruding sections are linked in the second direction by a corresponding linking section that has a shorter extension in the third direction than the protruding sections. Thus, grooves are formed in the support structure, which extend in the first direction from the distal end section of the support structure.

This particular configuration of the distal end section of the support structure enables the use of alternative damping mechanism that do not require a gluing step, thus reducing the production costs of the housing assembly.

In particular, the configuration of the distal end section of the support structure enables the use, in a subsequent step, of a liquid foam that is deposited onto the distal end section and that is configured to undergo a curing or hardening process. The liquid foam has predetermined curing parameters defining a transition from a liquid state to a solid state. Once cured, or hardened, the liquid foam forms the elastic element. The elastic element or the liquid foam, however, are not an essential feature of the housing section of the first aspect of the present invention. During the curing process of the liquid foam, a portion of the liquid foam flows along the grooves due to gravity and/or capillarity, and once cured, a first portion of the elastic element is stays on the protruding sections and on the linking sections and a second portion of the elastic element end up in at least a distal end section of the grooves. This provides an improved friction-based adhesive mechanical contact between the elastic element (cured liquid foam) and the support structure that avoids the need to glue an elastomeric strip to the support structure, thereby eliminating the costs associated to the precise provision of glue on the housing section (e.g., pre-processing of the housing section, and gluing process).

Further advantageous developments of the invention are found in the dependent claims and indicate in detail advantageous possibilities to realize the concept described above within the scope of the object as well as with regard to further advantages.

In the following, developments of the housing section of the first aspect of the invention will be disclosed.

In a development, the support structure is a single closed support structure i.e., forming a continuous support structure without ends. The support structure may comprise, in the longitudinal directions along which the length extension is measured, curved sections, straight sections or a combination of straight sections and curved sections. Here, the first, second and third directions refer to respective directions corresponding to each of the straight sections, or to each of the points of the curved sections.

In an alternative development, the support structure comprises one or more support sections, each support section having two ends in the longitudinal directions along which the length extension is measured. For instance, in a development, the support structure comprises two support sections arranged parallel to each other at a distance corresponding to a longitudinal extension of the PCB. In another development, the support structure comprises two pairs of support sections each support sections of a given pair being arranged parallel to each other, and the support sections of different pairs being arranged perpendicular to each other, wherein the distances between the corresponding support structures of a given pair correspond to a longitudinal extension of the PCB and to a width extension of the PCB respectively. The explanations regarding the direction and the extensions discussed above apply to each support section respectively.

In a development, a distal end surface of the protruding sections of the support structure presents a concave surface. This configuration favors the reception of the liquid foam that cures or hardens to form the elastic element. In a particular development, the concave surface of the distal end surface is such that a first extension of the support structure in the first direction at end sections of the protruding sections in the third direction is longer than a second extension of the support structure in the first direction at a central section of the protruding section.

Preferably, in development a ratio between an extension of the linking sections in the second direction and the extension of the linking sections in the third direction is between 0.7 and 1,7, preferably between 1.0 and 1.5, more preferably 1.2.

Additionally, or alternatively, in another development, a ratio between the extension of the linking sections in the second direction and an extension of the protruding sections in the second direction is between 0.6 and 1.5, preferably between 0.8 and 1.3, more preferably approximately 1.

In a development, the distal end section of the support structure is dimensioned to receive a liquid foam having predetermined curing parameters defining a transition from a liquid state to a solid state, such that the liquid foam, when cured, forms the elastic element, and wherein, when cured a first portion of the elastic element is arranged on the protruding sections and on the linking sections and a second portion of the elastic element is arranged in at least a distal end section of the grooves.

In a development, the elastic element is formed from an open-cell sponge rubber with an international rubber hardness degree of approximately 30 (30 $\pm$ 5 IRHD) with a closed skin made of ethylene-propylene-diene rubber (EPDM). Alternatively, the elastic element is formed from an open-cell sponge rubber (30 $\pm$ 5 IRHD) with a closed skin made of chloroprene rubber (CR). Alternatively, the elastic element is a closed-cell. flexible cellular rubber (30 $\pm$ 5 IRHD) made of chloroprene rubber (CR). Alternatively, the elastic element is formed from an open-cell sponge rubber (40 $\pm$ 5 IRHD) with a closed skin made of chloroprene rubber (CR). Alternatively, the elastic material is formed from an open-cell sponge rubber (50 $\pm$ 5 IHDR) with a closed skin made of hydrogenated-nitrile-butadiene-rubber (HNBR). Alternatively, the elastic element is formed from a predominantly closed silicone rubber (10 $\pm$ 2 IRDH), slightly thixotropic, addition-curing two-component silicon rubber, which cures to form a mainly closed-cell foam (VQM)

A second aspect of the present invention is formed by a housing assembly for housing a printed circuit board based electrical circuit. The housing assembly comprises a housing section in according to the first aspect of the invention, as a first housing section, and a second housing section that is configured to cooperate with the first housing section for holding a printed circuit board between the elastic element to be placed between on the distal end surface of the support structure and the second housing section.

The housing assembly is thus configured to enclose the PCB based electrical circuit and the first and the second housing sections, in an assembled state, form an inner volume in which the PCB based electrical circuit is arranged.

The housing assembly of the second aspect of the invention this shares the advantages of the housing section of the first aspect.

In the following, developments of the housing assembly of the second aspect will be disclosed.

In a development of the housing assembly of the second aspect, the first housing section or the second housing section (preferably the first housing section) comprises a peripheral groove and the remaining one of the first housing section or the second housing section (preferably the second housing section) comprises a cooperating peripheral protruding element arranged and configured to cooperate with the peripheral groove for closing the housing assembly.

The peripheral groove is, in a particular development, a closed groove in the form of a loop, i.e., with no ends. In an alternative development, the peripheral groove, has one or more groove sections. The peripheral protruding element is designed and configured to cooperate with the peripheral groove to fix the relative positions of the first housing section and the second housing section. Additionally, the cooperating peripheral groove and peripheral protruding element can be configured to provide a locking mechanism for locking, preferably releasably attaching and locking, the first housing section to the second housing section.

In another development, the first housing section and the second housing section comprise alternative locking elements for releasably attaching the first housing section to the second housing section and/or for fixing the relative positions of the first housing section and the second housing section.

In yet another development, the housing assembly further comprising an elastic sealing element arranged between a bottommost section of the peripheral groove and a distal end section of the peripheral protruding element. In an assembled state of the housing, this elastic sealing element protects the inner volume of the housing from contamination (e.g., dust, oil, humidity) from the environment. This is particularly beneficial in outdoor applications, such as in automotive applications. Further, the elastic sealing element further provides vibration mitigation properties to the housing assembly.

Preferably, in a development, the elastic sealing element arranged between the peripheral groove and the peripheral protruding element comprises, preferably is, the same material as the elastic material to be placed between the support structure and the printed circuit board. Preferably, the same liquid foam is applied to the groove and to the distal end section of the support structure, thus further reducing the production costs of the housing assembly.

A third aspect of the present invention is formed by a printed circuit board assembly that comprises a housing in accordance with the second aspect of the invention. The PCB assembly further comprises an elastic material placed on the distal end section of the support structure and a printed circuit board based electrical circuit arranged between the elastic material and the second housing section.

The printed circuit board assembly of the third aspect thus shares the advantages of the housing section of the first aspect and of the housing assembly of the second aspect.

In a development of the printed circuit board assembly of the third aspect, the second housing section comprises electrical connectors that transverse the second housing section. The electrical connectors comprise respective proximal ends, for electrically contacting the printed circuit board and respective distal ends, arranged on an outer surface of the housing, and configured to provide electrical access to the printed circuit board.

Preferably, in a development the printed circuit board based electrical circuit that is arranged inside the housing assembly is mechanically supported on opposite sides thereof by the elastic material placed on the distal end section of the support structure and by the respective proximal ends of the electrical connectors.

The housing section according to the first aspect of the invention is advantageously configured to provide, via the structured distal end section of the support structure, a fixing structure for the elastic material, in particular in the form of a cured liquid foam, that does not require any gluing. At the same time, the elastic material, when the housing section is used in a housing assembly to house a PCB based electrical circuit to form a PCB assembly, provides damping properties that reduce the vibrations experienced by the PCB based electrical circuit, in particular in applications such as automotive applications. Further it improves the positioning of the PCB based electrical circuit and prevents or at least minimizes PCB deformation, further preventing or minimizing damage on the PCB, e.g., cause by scratching between the PCB and other hard elements of the PCB assembly. Also, since the movement of the PCB with respect to the housing is minimized, the risk of breaking the pins due to said movement is reduced.

A fourth aspect of the present invention is directed to a vehicle, in particular commercial vehicle, that comprises a printed circuit board assembly according to the third aspect of the invention, wherein the PCB based electrical circuit is implemented as part of a control system for controlling the vehicle. Suitable control systems include, but are not limited to, a suspension system and a braking system. The PCB based electrical circuit can be part of an electronic control unit (ECU) of the vehicle.

These and other aspects of the invention will be apparent from and elucidated with reference to the embodiments described hereinafter.

The embodiments of the invention are described in the following on the basis of the drawing in comparison with the state of the art, which is also partly illustrated. The latter is not necessarily intended to represent the embodiments to scale. The drawing is, where useful for explanation, shown in schematized and/or slightly distorted form. With regard to additions to the teaching immediately recognizable from the drawing, reference is made to the relevant prior art. It should be kept in mind that numerous modifications and changes can be made to the form and detail of an embodiment without deviating from the general concept of the invention. The features of the invention disclosed in the description, in the drawing and in the claims may be essential for a further development of the invention, either individually or in any combination. In addition, all combinations of at least two of the features disclosed in the description, drawing and/or claims fall within the scope of the invention.

The general concept of the invention is not limited to the exact form or detail of the preferred embodiments shown and described below or to a subject matter, which would be limited in comparison to the subject matter as claimed in the claims.

For specified design ranges, values within specified limits of the ranges are also disclosed as limit values and thus are arbitrarily applicable and claimable.

The following drawing shows in:

FIG. 1    a partial view of an exemplary PCB assembly according to an embodiment of the invention;

FIG. 2    a partial view of an exemplary housing section in according to an embodiment of the invention;

FIG. 3    a partial view of another exemplary housing section in according to an embodiment of the invention;

FIG. 4    a schematic block diagram showing an exemplary support structure of a housing section in accordance with an embodiment of the invention with a cured liquid foam as the elastic material arranged on the support structure; and

FIG. 5    an schematic block diagram of a vehicle comprising a PCB assembly in accordance with an embodiment of the invention

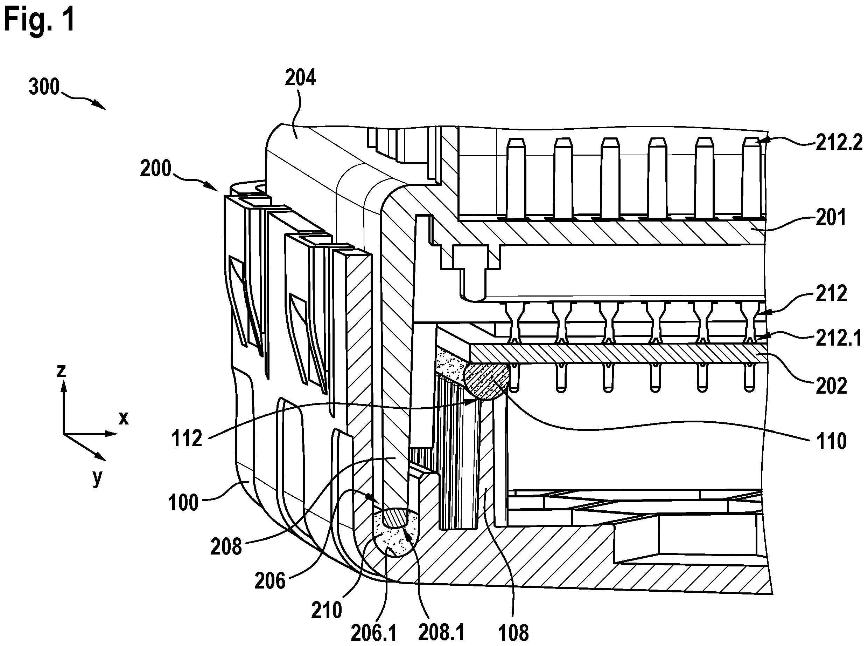

FIG. 1 shows a partial view of an exemplary printed circuit board assembly 300 according to an embodiment of the invention. The exemplary PCB assembly 300 of Fig. 1 comprises, comprises a housing assembly 200 formed by a first housing section and a second housing section, which, in Fig. 1, are shown in an assembled state. The first housing section 100 and the second housing section 204 are provided separately and assembled together, preferably in a releasably manner, to form the housing assembly 200. The first housing section 100 comprises a support structure 108 onto which an elastic material is arranged. As shown in Fig. 1, the elastic material is 110 placed on a distal end section 112 of the support structure 108. Further, a printed circuit board based electrical circuit 202 is arranged between the elastic material 110 and the second housing section 204. In the particular and non-limiting example shown in Fig. 1, the second housing section 204 comprises electrical connectors 212 that transverse the second housing section 204. The electrical connectors 212 are configured to provide electrical access to the printed circuit board based electrical circuit 202 from outside the housing assembly 200. The second housing section 204 can for instance comprise an electrical socket according to any suitable connection standard for electrical connections. The electrical connectors 212 comprise respective proximal ends 212.1 that are connected to connection pads on the PCB for electrically contacting the printed circuit board based electrical circuit (202), for example via contact pins, welded connections, etc. The electrical connectors 212 also comprise respective distal ends 212.2. The distal ends of the electrical connectors 212 are arranged on an outer surface 204.1 of the second housing section 204. External equipment or devices can be connected to the distal ends 212.2 of the electrical connectors 212, for electrically accessing the printed circuit board based electrical circuit 202. A given electrical connector 212 can include a single rigid pin, a single wire, or one or more pins connected to a wire.

Optionally, as shown in the exemplary PCB assembly 300 of Fig. 1, the printed circuit board based electrical circuit 202 that is arranged inside the housing assembly 200 is mechanically supported on opposite sides thereof by the elastic material 100 placed on the distal end section 112 of the support structure 108 and by the respective proximal ends 212.1 of the electrical connectors 212. The presence of the elastic material 110 mitigates the effects of vibrations on the PCB electrical circuit, for example, when the PCB assembly is used in a moving vehicle, for example as a controller unit for a given vehicle system, such as a suspension system. Further it improves the positioning of the PCB based electrical circuit and prevents or at least minimizes PCB deformation, further preventing or minimizing damage on the PCB, e.g., cause by scratching between the PCB and other hard elements of the PCB assembly. Also, since the movement of the PCB with respect to the housing is minimized, the risk of breaking the pins due to said movement is reduced.

Also optionally, in the PCB assembly 300 of Fig. 1, the housing assembly 200 comprises a first housing section 100 that includes a peripheral groove 206. The second housing section 204 comprises a cooperating peripheral protruding element 208 that is arranged and configured to cooperate with the peripheral groove 206 of the first housing section 100 for closing the housing assembly 200. In particular, in the PCB assembly 300 of Fig. 1, the housing assembly 200 further comprising an elastic sealing element 210 that is arranged between a bottommost section 206.1 of the peripheral groove 206 and a distal end section 208.1 of the peripheral protruding element 208. This, in an assembled state of the housing assembly 200, the elastic sealing element 210 is advantageously configured to protect the inner volume of the housing arrangement 200, and thus the PCB based electrical circuit 202 and in particular its electrical components housed therein, from contamination (e.g., dust, humidity, oil) from the environment. This is particularly beneficial in outdoor applications, such as in automotive applications. Further, the elastic sealing element 210 further provides vibration mitigation properties to the housing assembly.

Preferably, for example to reduce the production costs of the housing assembly 200, the elastic sealing element 210 that is arranged between the bottommost section 206.1 of the peripheral groove 206 and the distal end section 208.1 of the peripheral protruding element 208 comprises the same material as the elastic material 110 placed between the support structure 108 and the printed circuit board based electrical circuit 204.

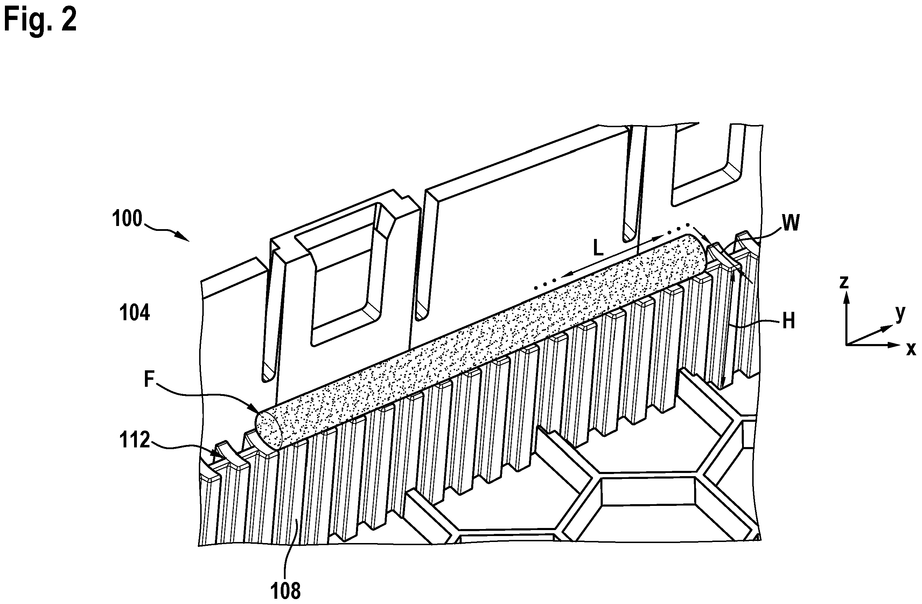

FIG. 2 shows a partial view of an exemplary housing section 100 in according to an embodiment of the invention. The housing section 100 is configured to be part of a housing assembly 200 (see Fig. 1) for housing a printed circuit board based electrical circuit 202. The housing section 100 (e.g., first housing section in Fig. 1) comprises a support structure 108 that arranged and configured for receiving an elastic element 110, which, in an assembled state of the housing assembly 200 of the PCB assembly 300 (see Fig. 1), is placed between the support structure 108 and the printed circuit board based electrical circuit 202.

The support structure 108 has a height extension H in a first direction z, a length extension L in a second direction y perpendicular to the first direction z, and a width extension W in a third direction x perpendicular to the first direction z and to the second direction y.

Fig. 2 also shows a liquid foam F that has been deposited on the support structure 108. The liquid foam F has predetermined curing parameters (e.g., curing time, viscosity as a function of the curing time) that define a transition from a liquid state of the liquid foam F to a solid state thereof. The liquid foam F, when cured, forms the elastic element 110 (see Fig. 1).

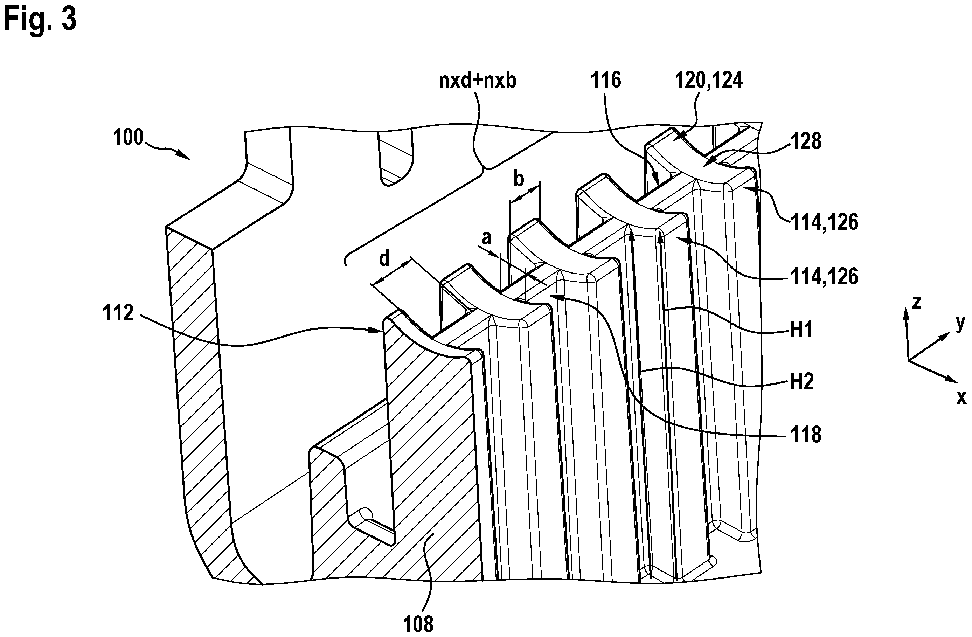

As seen with more detail in Fig. 3, which also shows partial view of an exemplary housing section 100 in according to an embodiment of the invention, the support structure 108 comprises, at a distal end section 112 thereof, in the first direction z, a plurality of protruding sections 114 that extend in the third direction x, wherein pairs of neighboring protruding sections 114 are linked in the second direction y by a corresponding linking section 116. The linking sections 116 have a shorter extension in the third direction x than the protruding sections 114, and thus, grooves 118 are formed in the support structure 108 that extend downwards from the perspective shown in Fig. 3 in the first direction z from the distal end section 112.

In the exemplary support structure shown in Fig. 3, a distal end surface 120 of the protruding sections 114 presents a concave surface 124. Thus, in the example shown in FIG 1, this means that a first extension H1 of the support structure 108 in the first direction z determined at end sections 126 of the protruding sections 114 in the third direction x is longer than a second extension H2 of the support structure 108 determined in the first direction z at a central section 128 of the protruding section 114. In other words, the surface is concave when looked from the third direction z towards the base, or proximal section, of the support structure that is opposite the distal end section 112.

Preferably, a ratio between an extension d of the linking sections 116 in the second direction y and the extension a of the linking sections 116 in the third direction x is between 0.7 and 1.7, preferably between 1 and 1.5, more preferably 1.2.

Also, preferably, a ratio between the extension d of the linking sections 116 in the second direction y and an extension b of the protruding sections 114 in the second direction y is between 0.6 and 1.5, preferably between 0.8 and 1.3, more preferably approximately 1.

For instance, in a preferred embodiment, the distal end surface 120 of the protruding sections 114 of the support structure 108 presents a concave surface with a radius R. The preferred range of values for the extension a of the linking sections 116 in the third direction x is delimited by a maximum value:

$$a_{MAX} = \frac{2 \times R}{3} + 0.5$$

and a minimum value:

$$a_{MIN} = \frac{2 \times R}{3} - 0.2$$

For a radius of 2.5 cm, the preferred value of a is thus between 2.2cm and 1.5 cm.

The preferred extension b of the protruding sections 114 in the second direction is between 1.75 and 2.5 cm. The preferred extension d of the linking sections 116 in the second direction y is between 1.5 and 2.5 cm.

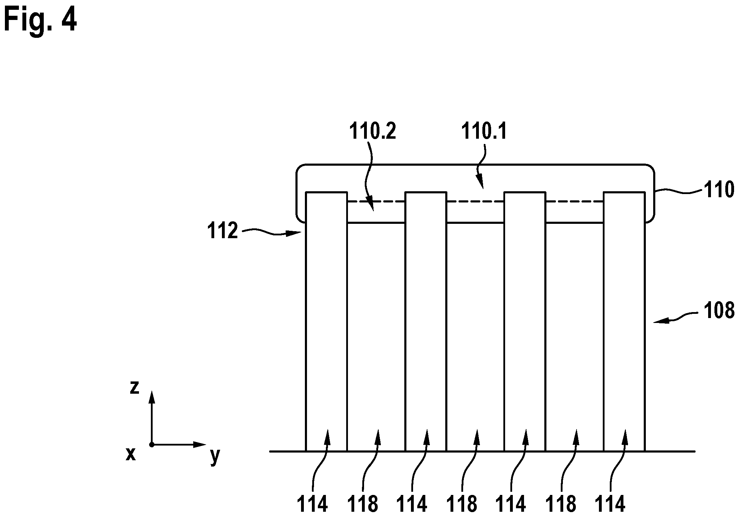

FIG. 4 shows an schematic block diagram showing an exemplary support structure 108 of a (first) housing section 100 in accordance with an embodiment of the invention with a cured liquid foam as the elastic material 110 arranged on the support structure 108, in particular on the distal end section 112 thereof. When the liquid foam is cured, as show in Fig. 4, a first portion of the elastic element is arranged on the protruding sections 114 and on the linking sections 116 and a second portion of the elastic element is arranged in at least a distal end section of the grooves 118. Thus, when cured, the elastic material 110 interlocks with the rib-like structure of the distal end section 112 of the support structure 108 formed by the grooves 118 and the protruding section 114, and avoids the need for gluing the elastic material to the support structure.

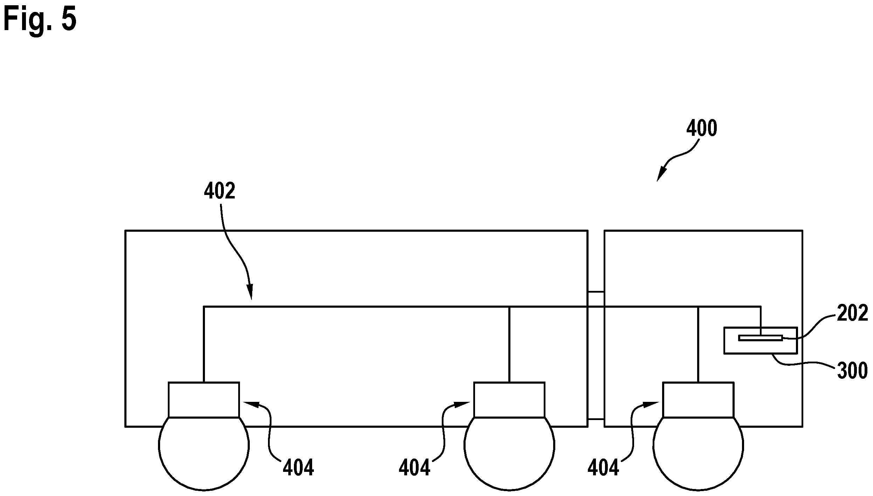

FIG. 5 shows a schematic block diagram of a vehicle, in particular a commercial vehicle 400 that comprising a PCB assembly 300 in accordance with an embodiment of the invention. In the vehicle 400 of Fig. 5, the PCB based electrical circuit 202 is implemented as part of a control system 402 for controlling the vehicle 400, for instance as part of a suspension control system and it is electrically or signally connected to suspension units 404 of the commercial vehicle.

In summary, the invention is directed to a housing section of a housing assembly for housing a printed circuit board based electrical circuit, which comprises a support structure configured for receiving an elastic element to be placed between the support structure and the printed circuit board based electrical circuit. The support structure comprises, a distal end section in a first direction, a plurality of protruding sections that extend in a perpendicular second direction, wherein pairs of neighboring protruding sections are linked in a perpendicular third direction by a corresponding linking section having a shorter extension in the third direction than the protruding sections and forming grooves in the support structure that extend in the first direction from the distal end section.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

A single unit or device may fulfill the functions of several items recited in the claims. The mere fact that certain measures are recited in mutually different dependent claims does not indicate that a combination of these measures cannot be used to advantage.

Any reference signs in the claims should not be construed as limiting the scope.

REFERENCE LIST (PART OF THE DESCRIPTION)

| | |
|---|---|
| 100 | First housing section |
| 108 | Support structure |
| 110 | Elastic material (cured liquid foam) |
| 112 | Distal end section of support structure |
| 114 | Protruding section |
| 116 | Linking section |
| 118 | Groove |
| 120 | Distal end surface of the support structure |
| 124 | Concave surface |
| 126 | End section of protruding section |
| 128 | Central section of protruding section |
| 200 | Housing assembly |
| 202 | PCB-based electrical circuit |
| 204 | Second housing section |
| 204.1 | Outer surface of second housing section |
| 206 | Peripheral groove |
| 206.1 | Bottommost section of peripheral groove |
| 208 | Peripheral protruding element |
| 208.1 | Distal end section of peripheral protruding element |
| 210 | Elastic sealing element |
| 212 | Electrical connector |
| 212.1 | Proximal end of electrical connector |

| | |
|---|---|
| 212.2 | Distal end of electrical connector |
| 300 | Printed circuit board assembly |
| 400 | Commercial vehicle |
| 402 | Control system |
| 404 | Suspension unit |
| a | Extension of linking section in third direction |
| b | Extension of protruding section in second direction |
| d | Extension of linking section in the second direction |
| F | Liquid foam |
| H | Height extension of support structure (in first direction) |
| H1 | First height extension |
| H2 | Second height extension |
| L | Length extension of support structure (in second direction) |
| W | Width extension of support structure (in third direction) |
| x | Third direction |
| y | Second direction |
| z | First direction |

**Claims**

1. Housing section (100) of a housing assembly (200) for housing a printed circuit board based electrical circuit (202) to be arranged between the housing section and a cooperating second housing section (204), the housing section (104) comprising:

   - a support structure (108) arranged and configured for receiving an elastic element (110) to be placed between the support structure (108) and the printed circuit board based electrical circuit (202), the support structure (108) having a height extension (H) in a first direction (z), a length extension (L) in a second direction (y) perpendicular to the first direction (z), and a width extension (W) in a third direction (x) perpendicular to the first direction (z) and to the second direction (y);

   **characterized in that**, the support structure (108), at a distal end section (112) in the first direction (z), comprises a plurality of protruding sections (114) that extend in the third direction (x), wherein pairs of neighboring protruding sections (114) are linked in the second direction (y) by a corresponding linking section (116) having a shorter extension in the third direction (x) than the protruding sections (114) and forming grooves (118) in the support structure (108) that extend in the first direction (z) from the distal end section (112).

2. The housing section of claim 1, wherein a distal end surface (120) of the protruding sections (114) of the support structure (108) presents a concave surface (124).

3. The housing section of claim 1 or 2, wherein a ratio between an extension (d) of the linking sections (116) in the second direction (y) and the extension (a) of the linking sections (116) in the third direction (x) is between 0.7 and 1.7, preferably between 1 and 1.5, more preferably 1.2.

4. The housing section of any of the preceding claims, wherein a ratio between the extension (d) of the linking sections (116) in the second direction (y) and an extension (b) of the protruding sections (114) in the second direction (y) is between 0.6 and 1.5, preferably between 0.8 and 1.3, more preferably 1.

5. The housing section of any of the preceding claims, wherein the distal end section 112 of the support structure (108) is dimensioned to receive a liquid foam (F) having predetermined curing parameters defining a transition from a liquid state to a solid state, such that the liquid foam (F), when cured, forms the elastic element (110), and wherein, when cured, a first portion (110.1) of the elastic element (110) is arranged on the protruding sections (114) and on the linking sections (116) and a second portion (110.2) of the elastic element (110) is arranged in at least a distal end section of the grooves (118).

6. Housing assembly (200) for housing a printed circuit board based electrical circuit (202), comprising:

   - a housing section (100) in according to any of the preceding claims, as a first housing section; and
   - a second housing section (204) configured to cooperate with the first housing section (100) for holding a printed circuit board based electrical circuit (202) between an elastic element (110) to be placed between on the distal end section (112) of the support structure (108) and the second housing section (204).

7. The housing assembly (200) of claim 6, wherein the first housing section (100) or the second housing section (204) comprises a peripheral groove (206) and the remaining one of the first housing section (100) or the second housing section (204) comprises a cooperating peripheral protruding element (208) arranged and configured to cooperate with the peripheral groove (206) for closing the housing assembly (200).

8. The housing assembly (200) of claim 6 or 7, further comprising an elastic sealing element (210) arranged between a bottommost section (206.1) of the peripheral groove (206) and a distal end section (208.1) of the peripheral protruding element (208).

9. The housing assembly (200) of claim 8, wherein the elastic sealing element (210) arranged between the bottommost section (206.1) of the peripheral groove (206) and the distal end section (208.1) of the peripheral protruding element (208) comprises the same material as the elastic material (110) to be placed between the support structure (108) and the printed circuit board based electrical circuit (102).

10. Printed circuit board assembly (300), comprising:

    - a housing assembly (200) in accordance with any of the preceding claims 6 to 9,
    - an elastic material (110) placed on the distal end section (112) of the support structure (108); and
    - a printed circuit board based electrical circuit (202) arranged between the elastic material (110) and the second housing section (204).

11. The printed circuit board assembly (300) of claim 10, wherein the second housing section (204) comprises electrical connectors (212) that transverse the second housing section (204), wherein the electrical connectors (212) comprise respective proximal ends (212.1), for electrically contacting the printed circuit board based electrical circuit (202) and respective distal ends (212.2), arranged on an outer surface (204.1) of the second housing section (204), and configured to provide electrical access to the printed circuit board based electrical circuit (202).

12. The printed circuit board assembly (300) of claim 11, wherein the printed circuit board based electrical circuit (202) arranged inside the housing assembly (200) is mechanically supported on opposite sides thereof by the elastic material (100) placed on the distal end section (112) of the support structure (108) and by the respective proximal ends (212.1) of the electrical connectors (212).

13. Vehicle (400), in particular commercial vehicle (400), comprising a printed circuit board assembly (300) according to any of the claims 10 to 12, wherein the PCB based electrical circuit (202) is implemented as part of a control system (402) for controlling the vehicle (400).

**Fig. 1**

**Fig. 2**

# Fig. 3

EP 4 780 146 A1

EP 4 780 146 A1

**Fig. 4**

EP 4 780 146 A1

**Fig. 5**

Europäisches
Patentamt

European
Patent Office

Office européen
des brevets

## EUROPEAN SEARCH REPORT

**Application Number**

**EP 25 15 1937**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 2 653 019 B1 (BOSCH GMBH ROBERT [DE]) 26 April 2017 (2017-04-26) * the whole document * ----- | 1-13 | INV. H05K5/00 |
| A | US 2009/316372 A1 (KOZLOVSKI ALBERT DAVID [US]) 24 December 2009 (2009-12-24) * the whole document * ----- | 1-13 | |
| A | US 2020/146161 A1 (ZACK DARREN M [US] ET AL) 7 May 2020 (2020-05-07) * the whole document * ----- | 1-13 | |
| A | US 7 309 264 B2 (DENSO CORP [JP]) 18 December 2007 (2007-12-18) * the whole document * ----- | 1-13 | |
| | | | **TECHNICAL FIELDS SEARCHED (IPC)** |
| | | | H05K |

The present search report has been drawn up for all claims

| Place of search | Date of completion of the search | Examiner |
|---|---|---|
| The Hague | 8 July 2025 | Lourenco Carreno, T |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

......................................................................................

& : member of the same patent family, corresponding document

EPO FORM 1503 03.82 (P04C01)

EP 4 780 146 A1

## ANNEX TO THE EUROPEAN SEARCH REPORT
## ON EUROPEAN PATENT APPLICATION NO.

EP 25 15 1937

08-07-2025

| Patent document cited in search report | | Publication date | Patent family member(s) | | | Publication date |
|---|---|---|---|---|---|---|
| EP 2653019 | B1 | 26-04-2017 | CN | 103262674 | A | 21-08-2013 |
| | | | DE | 102010063151 | A1 | 21-06-2012 |
| | | | EP | 2653019 | A1 | 23-10-2013 |
| | | | WO | 2012079837 | A1 | 21-06-2012 |
| US 2009316372 | A1 | 24-12-2009 | NONE | | | |
| US 2020146161 | A1 | 07-05-2020 | NONE | | | |
| US 7309264 | B2 | 18-12-2007 | JP | 4196904 | B2 | 17-12-2008 |
| | | | JP | 2006066623 | A | 09-03-2006 |
| | | | US | 2006044768 | A1 | 02-03-2006 |

EPO FORM P0459

EP 4 780 146 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0353443 A2